# EUROPÄISCHE PATENTSCHRIFT

(11) **EP 1 001 464 B1**
(45) Veröffentlichungstag und Bekanntmachung des Hinweises auf die Patenterteilung: **31.10.2007**
(21) Anmeldenummer: 99112077.5
(22) Anmeldetag: 23.06.1999
(51) Int. Cl.: H01L 23/64, H01L 23/48

(54) **Monolithisch integrierte Schaltung mit mehreren Kapazitäten**
Monolithic integrated circuit comprising a plurality of capacitors
Circuit intégré monolithique comprenant une pluralité de condensateurs

(30) Priorität: 09.11.1998 DE 19851458
(43) Veröffentlichungstag der Anmeldung: 17.05.2000
(73) Patentinhaber: Ericsson AB, Stockholm (SE)
(72) Erfinder: Gerhard, Gregor, 71540 Murrhardt (DE)
(74) Vertreter: Heuer, Wilhelm

(56) Entgegenhaltungen:
- EP-A- 0 000 384
- EP-A- 0 397 391
- EP-A- 0 545 809
- FR-A- 2 609 841
- FR-A- 2 621 174
- US-A- 5 465 007
- PATENT ABSTRACTS OF JAPAN vol. 1996, no. 08, 30. August 1996 (1996-08-30) & JP 08 088320 A (MITSUBISHI ELECTRIC CORP), 2. April 1996 (1996-04-02)

## Beschreibung

### Stand der Technik

Die vorliegende Erfindung betrifft eine monolithisch integrierte Schaltung mit mehreren einen Nebenschluß nach Masse bildenden Kapazitäten, wobei jede Kapazität aus zwei auf einem Substrat aufgebrachten, durch eine dielektrische Schicht voneinander getrennten leitenden Belägen besteht und die auf dem Substrat unterhalb der dielektrischen Schicht liegenden unteren Beläge mit einer Masseleitung auf der gegenüberliegenden Substratseite kontaktiert sind.

Ein derartiger Aufbau von monolithisch integrierten Kapazitäten ist aus dem "Design Guide, GaAs FoundryServices" von Texas Instruments, Version 4.2, Februar 1997, Seite 1 - 6 und aus FR-A 2609841 bekannt.

Bei einer monolithisch integrierten Mikrowellenschaltung (MMIC) wird üblicherweise eine möglichst hohe Packungsdichte der einzelnen Schaltelemente angestrebt. Gehören zu einer Schaltung mehrere einen Nebenschluß nach Masse bildende Kapazitäten, so ist wegen der Masseverbindungen der Kapazitäten über Durchkontaktierungen im Substrat ein relativ großer Abstand zwischen den Kapazitäten einzuhalten, weil bei einem zu geringen Abstand der Durchkontaktierungen das Substrat zu zerbrechen droht. Die minimal zulässigen Abstände zwischen den Durchkontaktierungen sind auch deshalb relativ groß, weil die Durchmesser der Durchkontaktierungen zu der mit der Masseleitung versehenen Substratunterseite hin konisch zunehmen, was für die Herstellung der Durchkontaktierungen aus technologischen Gründen unumgehbar ist. Schaltungen mit mehreren einen Nebenschluß nach Masse bildenden Kapazitäten sind z. B., wie aus IEEE Transactions on Microwave Theory and Techniques, Vol. 45, No. 12, Dezember 1997, Seite 2256 - 2260 hervorgeht, in Verstärkerschaltungen zum Abblocken von Hochfrequenzsignalen gegenüber Vorspannungsschaltkreisen erforderlich.

Der Erfindung liegt daher die Aufgabe zu Grunde, eine monolithisch integrierte Schaltung mit mehreren einen Nebenschluß nach Masse bildenden Kapazitäten anzugeben, bei der die Kapazitäten mit möglichst geringen Abständen zueinander angeordnet sein können.

### Vorteile der Erfindung

Die genannte Aufgabe wird mit den Merkmalen des Anspruchs 1 dadurch gelöst, daß von den Kapazitäten, welche jeweils aus zwei auf einem Substrat aufgebrachten, durch eine dielektrische Schicht voneinander getrennten leitenden Belägen bestehen, die unteren Beläge der Kapazitäten miteinander verbunden sind und nur der zu einer Kapazität gehörende untere Belag über eine Durchkontaktierung im Substrat mit der Masseleitung kontaktiert ist. Auf Grund dieser Maßnahmen muß nicht mehr für jede einzelne Kapazität eine eigene Durchkontaktierung vorgesehen werden, wodurch sich die minimal zulässigen Abstände zwischen den Kapazitäten erheblich verringern.

Vorteilhafte Weiterbildungen der Erfindung gehen aus den Unteransprüchen hervor. Danach ist es zweckmäßig, die unteren Beläge aller Kapazitäten aus einem gemeinsamen unteren Belag zu bilden. Außerdem ist es zweckmäßig, daß bei Kapazitäten, die für unterschiedliche Frequenzbereiche dimensioniert sind, die Durchkontaktierung für diejenige Kapazität vorzusehen, die für einen höheren Frequenzbereich dimensioniert ist, als die andere(n) Kapazität(en).

Vorzugsweise kann die Schaltung aus mehreren einen Nebenschluß gegen Masse bildenden Kapazitäten in einer Verstärkerschaltung eingesetzt werden, um Hochfrequenzsignale gegenüber einer Vorspannung abzublocken. Zu diesem Zweck können zwei einen Nebenschluß gegen Masse bildende Kapazitäten parallel geschaltet werden, wobei eine der beiden Kapazitäten für Hochfrequenzsignale im Betriebsfrequenzband des Verstärkers und die andere Kapazität für Hochfrequenzsignale unterhalb des Betriebsfrequenzbandes einen Kurzschluß nach Masse bildet.

### Zeichnung

Anhand eines in der Zeichnung dargestellten Ausführungsbeispiels wird nachfolgend die Erfindung näher erläutert. Es zeigen:
Fig. 1 das Schaltbild einer mit zwei massekontaktierten Kapazitäten beschalteten Verstärkerstufe,
Fig. 2 die Draufsicht auf zwei monolithisch integrierte Kapazitäten und
Fig. 3 einen Querschnitt A-A durch die Schaltung der Fig. 2.

### Beschreibung eines Ausführungsbeispiels

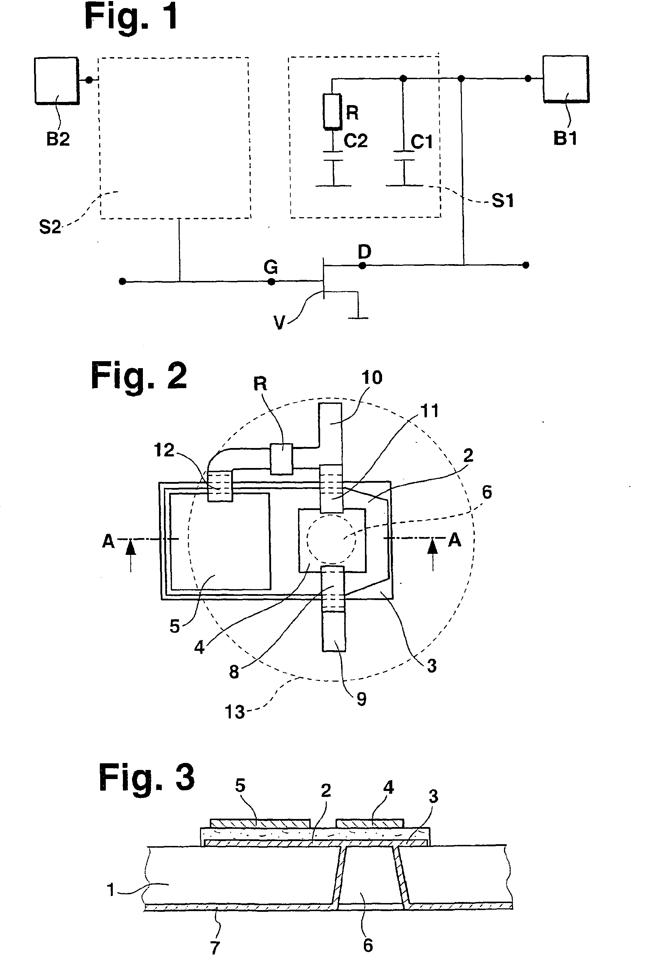

In der Fig. 1 ist eine Schaltung S1 dargestellt mit zwei einen Nebenschluß nach Masse bildenden Kapazitäten C1 und C2, wobei der Kapazität C2 noch ein ohmscher Widerstand R in Reihe geschaltet ist. Eine solche Schaltung S1 findet, wie Fig. 1 zeigt, z. B. Einsatz in einer Verstärkerstufe V, die beispielsweise aus einem Feldeffektstransistor besteht. Die Schaltung S1 mit den zwei einen Nebenschluß nach Masse bildenden Kapazitäten C1 und C2 ist an den Ausgang des Verstärkers V, hier die Drain-Elektrode D des Feldeffekttransistors, angeschlossen, um die Hochfrequenzsignale am Ausgang des Verstärkers V gegenüber einem Vorspannungsnetzwerk B1 abzublocken. Zu dem gleichen Zweck kann auch eine Schaltung S2, die ähnlich aufgebaut ist wie die Schaltung S1, an den Eingang des Verstärkers V, hier die Gate-Elektrode G des Feldeffekttransistors angeschlossen werden, um die Hochfrequenzeingangssignale gegenüber einem Vorspannungsnetzwerk B2 abzublocken. Abgesehen von dem in der Fig. 1 dargestellten Ausführungsbeispiel gibt es auch andere Einsatzfälle für Schaltungen mit mehreren einen Nebenschluß nach Masse bildenden Kapazitäten.

Damit die beiden Kapazitäten C1 und C2 in einem möglichst geringen Abstand auf einem Substrat monolithisch integriert werden können, wird für beide Kapazitäten C1 und C2 nur eine einzige Durchkontaktierung für den Masseanschluß vorgesehen. Damit kann darauf verzichtet werden, für jede Kapazität eine eigene Durchkontaktierung vorzusehen, in Folge dessen der einzuhaltende zulässige minimale Abstand zwischen den Kapazitäten relativ groß wäre.

In der Fig. 2 ist eine Draufsicht auf zwei auf einem Substrat monolithisch integrierte Kapazitäten und in Fig. 3 ein Querschnitt A-A durch das Substrat mit den darauf befindlichen Kapazitäten dargestellt. Auf einem Substrat 1, das z. B. ein GaAs-Substrat ist, ist ein unterer leitender Belag 2 aufgebracht, der für beide Kapazitäten eine erste Elektrode darstellt. Auf dem unteren Belag 2 befindet sich eine dielektrische Schicht 3, und auf dieser dielektrischen Schicht 3 sind zwei obere leitende Beläge 4 und 5 aufgebracht, welche die zweite Elektrode für die beiden Kapazitäten bilden. Beide Kapazitäten erhalten ihren Nebenschluß nach Masse durch eine einzige in das Substrat 1 eingebrachte Durchkontaktierung 6, welche den den beiden Kapazitäten gemeinsamen leitenden Belag 2 mit der auf der gegenüberliegenden Substratseite vorhandenen Masseleitung 7 verbindet. Der obere leitende Belag 4 der ersten Kapazität C1 ist über eine leitende Luftbrücke 8 mit einer zur Drain-Elekrode D führenden Anschlußleitung 9 verbunden. Eine Anschlußleitung 10, die zum Vorspannungsnetzwerk B1 führt ist sowohl über eine leitende Luftbrücke 11 mit dem oberen leitenden Belag 4 der ersten Kapazität C1 und über eine leitende Luftbrücke 12 mit dem oberen Belag 5 der zweiten Kapazität C2 verbunden. Der zu der Kapazität C2 in Reihe geschaltete Widerstand R ist in der Anschlußleitung zum oberen Belag 5 der zweiten Kapazität C2 integriert.

In der Fig. 2 ist durch einen strichlierten Kreis 13 um die Durchkontaktierung 6 herum angedeutet, welcher minimale Abstand einzuhalten wäre für eine weitere Durchkontaktierung, die erst außerhalb des Kreises 13 in das Substrat 1 eingebracht werden dürfte. Die Darstellung macht deutlich, daß die beiden Kapazitäten bei nur einer einzigen Durchkontaktierung erheblich näher nebeneinander angeordnet werden können, als wenn zwei Durchkontaktierungen vorgesehen würden.

Die Durchkontaktierung 6 wird zweckmäßigerweise direkt unterhalb derjenigen Kapazität angeordnet, die für den höheren Frequenzbereich dimensioniert ist. In dem dargestellten Ausführungsbeispiel ist die Kapazität C1 für den höheren Frequenzbereich, nämlich den Betriebsfrequenzbereich des Verstärkers V ausgebildet, wogegen die zweite Kapazität C2 für einen Frequenzbereich unterhalb des Betriebsfrequenzbandes dimensioniert ist. Je höher der Frequenzbereich ist, desto stärker wirken sich Leitungslängen als parasitäre Induktivitäten aus. Deshalb wird gerade mit der Lage der Durchkontaktierung 6 unterhalb der für den höheren Frequenzbereich ausgelegten Kapazität die Leitungslänge zwischen der Masseleitung 7 und dem unteren leitenden Belag 2 für diese Kapazität am geringsten. Für die andere Kapazität mit dem oberen leitenden Belag 5 ist zwar die Leitungslänge zwischen der Masseleitung 7 und ihrem unteren leitenden Belag 2 über die Durchkontaktierung 6 länger, wirkt sich aber weniger störend aus, weil diese Kapazität für einen geringeren Frequenzbereich ausgelegt ist.

## Patentansprüche

1. Monolithisch integrierte Schaltung mit mehreren einen Nebenschluß nach Masse bildenden Kapazitäten, wobei jede Kapazität aus zwei auf einem Substrat (1) aufgebrachten, durch eine dielektrische Schicht (3) voneinander getrennten leitenden Belägen (2, 4, 5) besteht und die auf dem Substrat (1) unterhalb der dielektrischen Schicht liegenden unteren Beläge (2) mit einer Masseleitung (7) auf der gegenüberliegenden Substratseite kontaktiert sind, **dadurch gekennzeichnet, daß** die unteren Beläge (2) der Kapazitäten miteinander verbunden sind und daß nur der zu einer Kapazität gehörende untere Belag (2) über eine Durchkontaktierung (6) im Substrat (1) mit der Masseleitung (7) kontaktiert ist.

2. Anordnung nach Anspruch 1, **dadurch gekennzeichnet, daß** die unteren Beläge aller Kapazitäten aus einem gemeinsamen unteren Belag (2) gebildet sind.

3. Anordnung nach Anspruch 1, **dadurch gekennzeichnet, daß** die Kapazitäten für unterschiedliche Frequenzbereiche dimensioniert sind und daß die Durchkontaktierung (6) für diejenige Kapazität vorgesehen ist, die für einen höheren Frequenzbereich dimensioniert ist als die andere(n) Kapazität(en).

4. Anordnung nach einem der vorgehenden Ansprüche, **dadurch gekennzeichnet, daß** sie in einer Verstärkerschaltung (V) eingesetzt ist, um Hochfrequenzsignale gegenüber einer Vorspannung abzublocken.

5. Anordnung nach Anspruch 4, **dadurch gekennzeichnet, daß** sie aus zwei parallel geschalteten, einen Nebenschluß nach Masse bildenden Kapazitäten (C1, C2) besteht, wobei eine (C1) der beiden Kapazitäten (C1, C2) für Hochfrequenzsignale im Betriebsfrequenzband des Verstärkers (V) und die andere Kapazität (C2) für Hochfrequenzsignale unterhalb des Betriebsfrequenzbandes einen Kurzschluß nach Masse bildet.

## Claims

1. Monolithic integrated circuit with multiple capacitors forming a shunt to ground, in which each capacitor consists of two conducting layers (2, 4, 5) mounted on a substrate (1) and separated from each other by a dielectric layer (3), and in which the lower layers (2) situated beneath the dielectric layer on the substrate (1) are connected to a ground connection (7) on the opposing substrate side, **characterised by** the lower layers (2) of the capacitors being connected to each other and only the lower layer (2) forming part of one capacitor being connected to the ground connection (7) via a plated-through hole (6) in the substrate (1).

2. Arrangement according to Claim 1, **characterised by** the lower layers of all capacitors being formed from a common lower layer (2).

3. Arrangement according to Claim 1, **characterised by** the capacitors being dimensioned for different frequency ranges and the plated-through hole (6) being designed for the capacitor that is dimensioned for a higher frequency range than the other capacitor(s).

4. Arrangement according to one of the preceding claims, **characterised by** said arrangement being employed in an amplifier circuit (V) in order to block high-frequency signals in respect to a bias voltage.

5. Arrangement according to Claim 4, **characterised by** said arrangement comprising two parallel-connected capacitors (C1, C2) forming a shunt to ground, whereby one (C1) of the two capacitors (C1, C2) forms a short to ground for high-frequency signals in the operating frequency range of the amplifier (V) and the other capacitor (C2) forms a short to ground for high-frequency signals beneath the operating frequency range.

## Revendications

1. Circuit intégré monolithique avec plusieurs condensateurs formant un circuit dérivé vers la masse, chaque condensateur étant composé de deux armatures (2, 4, 5) conductrices appliquées sur un substrat (1) et séparées l'une de l'autre par une couche diélectrique (3), les armatures inférieures (2) se trouvant sur le substrat (1) sous la couche diélectrique étant en contact avec une ligne de masse (7) sur le côté opposé du substrat, **caractérisé en ce que** les armatures inférieures (2) des condensateurs sont reliées entre elles et que seule l'armature inférieure (2) appartenant à un condensateur est en contact avec la ligne de masse (7) par le biais d'une métallisation de trou (6) dans le substrat (1).

2. Agencement selon la revendication 1, **caractérisé en ce que** les armatures inférieures de tous les condensateurs sont formées d'une armature inférieure commune (2).

3. Agencement selon la revendication 1, **caractérisé en ce que** les condensateurs sont dimensionnés pour différentes plages de fréquence et que la métallisation de trou (6) est prévue pour le condensateur qui est dimensionné pour une plage de fréquence supérieure à l'autre/aux autres condensateur(s).

4. Agencement selon l'une quelconque des revendications précédentes, **caractérisé en ce qu'**il est utilisé dans un circuit d'amplificateur (V) afin de bloquer des signaux haute fréquence par rapport à une polarisation.

5. Agencement selon la revendication 4, **caractérisé en ce qu'**il est composé de deux condensateurs (C1, C2) montés en parallèle, formant un circuit dérivé vers la masse, un (C1) des deux condensateurs (C1, C2) formant un court-circuit vers la masse pour des signaux haute fréquence dans la bande de fréquence de fonctionnement de l'amplificateur (V) et l'autre condensateur (C2) formant un court-circuit vers la masse pour des signaux haute fréquence en dessous de la bande de fréquence de fonctionnement.
